(19) **Europäisches Patentamt / European Patent Office / Office européen des brevets**

(11) **EP 4 032 106 B1**

(12) **EUROPÄISCHE PATENTSCHRIFT**

(45) Veröffentlichungstag und Bekanntmachung des Hinweises auf die Patenterteilung:
**08.01.2025 Patentblatt 2025/02**

(21) Anmeldenummer: **20780911.2**

(22) Anmeldetag: **15.09.2020**

(51) Internationale Patentklassifikation (IPC):
**G21K 1/06** (2006.01)   **G21K 7/00** (2006.01)
**G03F 1/84** (2012.01)   **G21K 1/10** (2006.01)

(52) Gemeinsame Patentklassifikation (CPC):
**G21K 1/06; G03F 1/84; G21K 7/00;** G21K 1/10

(86) Internationale Anmeldenummer:
**PCT/DE2020/100801**

(87) Internationale Veröffentlichungsnummer:
**WO 2021/052533 (25.03.2021 Gazette 2021/12)**

(54) **MIKROSKOPISCHES SYSTEM ZUR PRÜFUNG VON STRUKTUREN UND DEFEKTEN AUF EUV-LITHOGRAPHIE-PHOTOMASKEN**

MICROSCOPIC SYSTEM FOR TESTING STRUCTURES AND DEFECTS ON EUV LITHOGRAPHY PHOTOMASKS

SYSTÈME MICROSCOPIQUE POUR TESTER DES STRUCTURES ET DES DÉFAUTS SUR DES PHOTOMASQUES DE LITHOGRAPHIE EUV

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.09.2019 US 201962901165 P**
**17.09.2019 DE 102019124919**

(43) Veröffentlichungstag der Anmeldung:
**27.07.2022 Patentblatt 2022/30**

(73) Patentinhaber: **RI Research Instruments GmbH**
**51429 Bergisch Gladbach (DE)**

(72) Erfinder:
- **LEBERT, Rainer**
  **52488 Wipperfürth (DE)**
- **PHIESEL, Christoph Sebastian**
  **53474 Bad Neuenahr-Ahrweiler (DE)**
- **MISSALLA, Thomas**
  **07743 Jena (DE)**
- **BIERMANNS-FÖTH, Andreas**
  **51491 Overath (DE)**
- **PIEL, Christian**
  **51789 Lindlar (DE)**

(74) Vertreter: **Gleim Petri Patent- und Rechtsanwaltspartnerschaft mbB**
**Neugasse 13**
**07743 Jena (DE)**

(56) Entgegenhaltungen:
**DE-A1- 102007 041 939**

- **HEIKO FELDMANN ET AL: "Actinic review of EUV masks", PROCEEDINGS OF SPIE, vol. 7636, 3 March 2010 (2010-03-03), pages 76361C, XP055083691, ISSN: 0277-786X, DOI: 10.1117/12.848380**
- **SCHRIEVER G ET AL: "LASER-PRODUCED LITHIUM PLASMA AS A NARROW-BAND EXTENDED ULTRAVIOLETRADIATION SOURCE FOR PHOTOELECTRON SPECTROSCOPY", APPLIED OPTICS, OPTICAL SOCIETY OF AMERICA, WASHINGTON, DC, US, vol. 37, no. 7, 1 January 1998 (1998-01-01), pages 1243 - 1248, XP000920796, ISSN: 0003-6935, DOI: 10.1364/AO.37.001243**

# EP 4 032 106 B1

**Beschreibung**

Die Erfindung betrifft ein Mikroskopisches System zur Prüfung von Strukturen und Defekten auf EUV-Lithographie-Photomasken, insbesondere für reflektierende Photomasken in der EUV-Lithographie (EUVL) mit einer räumlichen Auflösung von besser als 50 nm.

Die optische Lithographie wird derzeit zur Herstellung elektronischer Chips in der Halbleiterindustrie eingesetzt. Vor kurzem wurde die Extreme Ultraviolett (EUV) - Lithographie (EUVL) bei $\lambda_{EUVL} \approx 13{,}5$ nm in die hochmoderne Chipherstellung für die nächste Generation von Chips mit minimalen Strukturgrößen von 7 nm und kleiner eingeführt. Jüngste Fortschritte in der EUVL haben das Lithographieverfahren unter Verwendung einer im Vakuum arbeitenden Stepper-Vorrichtung und einer mehrschichtig beschichteten Reflexionsoptik erfolgreich durchgeführt. Im Gegensatz zur optischen Lithographie können die Prozesse der EUVL und der aktinischen (durch Strahlung bei lithographischer Wellenlänge beeinflussten) Inspektion und Überprüfung nur im Vakuum durchgeführt werden, während die Prozessschritte der Lithographie und die folgenden Verarbeitungsschritte im Prinzip der optischen Lithographie ähnlich sind.

Masken für den EUVL-Prozess bei der Herstellung elektronischer Chips verwenden eine "Reflexionsmaske". Dazu wird zunächst ein EUV-Maskenrohling hergestellt, indem ein geeignetes defektfreies Substrat mit geringer Rauheit mit einem vielschichtigen Wechselschichtreflektorsystem beschichtet wird, z. 40 Molybdän- und Siliziumpaare mit Schichtdicken im Bereich von 7 nm. Der Maskenrohling wird dann durch ein geeignetes Verfahren strukturiert, z.B. Elektronenstrahlschreiben, um die Photomaske für den lithografischen Prozess zu erzeugen. Bei diesem Strukturierungsverfahren wird die reflektierende Oberfläche des EUV-Maskenrohlings mit Absorberstrukturen versehen, wie sie im Maskenlayout definiert sind. Das Muster auf der Maske stellt ein vergrößertes Bild der Strukturen in der Mikroschaltung dar, die unter Verwendung einer solchen EUV-Maske hergestellt werden soll.

Die für das EUVL-Verfahren verwendete Maske muss jedoch fehlerfrei sein. Da die Merkmale auf der Maske, durch die im EUVL-Verfahren vierfach kleinere Schaltungsstrukturen hergestellt werden, in der Größenordnung von wenigen 10 nm liegen (z. B. bis zu 28 nm Maskenmerkmale für 7 nm-Strukturen auf dem Chip), können Partikel oder Fehler der Absorberstrukturen auf der aktiven Fläche des Musters der Photomaske verursachen, die beim Belichten im EUVL-Verfahren zu einer fehlerhaften Bedruckung der Nanostrukturen und damit zu Fehlfunktionen der Mikroschaltung führen. Solche Defekte müssen ausgeschlossen werden.

Folglich ist es notwendig, die Maskenrohlinge vor der Strukturierung und die fertige Photomaske nach der Strukturierung auf Fehler zu untersuchen, um sicherzustellen, dass durch diesen Prozess keine Fehler im Musterbereich erzeugt wurden und die Strukturen wie vorgesehen gemustert sind. Dabei sind nach dem Auffinden derartiger Strukturfehler auf Photomasken oder Maskenrohlingen eine Überprüfung, ob gefundene Defekte für die auf dem Wafer erzeugten Strukturen kritisch sind, sowie eine Reparatur von kritischen Defekten und eine Inspektion der Defekte im Nanobereich erforderlich.

Auf dem Gebiet dieser Erfindung werden solche Defekte auf der Maske mit einem aktinischen EUV-Mikroskop überprüft. Dabei wird unter dem Attribut aktinisch verstanden, dass das Objekt (Photomaske) unter Original-Strahlungsbedingungen (hier: EUV-Wellenlänge und Bandbreite der späteren Arbeitswellenlänge) untersucht wird. Das Auflösungsvermögen des Mikroskops sollte dabei besser als die typische Strukturgröße der Photomaske (Ziel: 20 nm) sein und Einzelbilder sollen typischerweise in weniger als 10 s mit einer gewissen Flexibilität bei den Beleuchtungs- und optischen Abbildungseigenschaften aufgenommen werden können. Für den weit verbreiteten Einsatz in der Halbleiterindustrie und deren Zulieferkette muss ein solches Mikroskop in den weit verstreuten EUV-Labors eigenständig betrieben werden, was bedeutet, dass das EUV-Mikroskop an einer kompakten EUV-Quelle und nicht an einem großen Synchrotron-Strahlrohr-Labor betrieben wird. Als verfügbare Quellen mit ausreichender spektraler Helligkeit stehen nur die durch Laserbestrahlung oder schnelle Hochstromgasentladungen erzeugten Plasmaemissionen mit einer Temperatur von etwa 200.000 Kelvin zur Verfügung.

Beschreibung des Standes der Technik

Für die Inspektion von Maskenrohlingen und Mustern auf einer Maske - d. h. das Auffinden von Fehlern oder Unvollkommenheiten an den Maskenstrukturen - stehen in der Industrie Messwerkzeuge zur Verfügung, für die Patente bestehen:

- Für die aktinische Prüfung von Maskenrohlingen gibt es das von der japanischen Firma LASERTEC hergestellte Werkzeug ABIT (Actinic Blank Inspection Tool).
- Zum Auffinden von Fehlern oder Defekten auf der Maske gibt es Musterprüfwerkzeuge, die normalerweise noch optische Strahlung (> 150 nm) verwenden und als solche "nicht aktinisch" sind.
- Um zu überprüfen, ob und wie solche Merkmale oder Defekte in dem Maskendruck bei der Verwendung in der EUV-Scanner-Lithographie vorliegen, ist das EUV-AIMS (Areal Image Microscope System) von Zeiss ein Werkzeug der besten Wahl. Das EUV-AIMS ist bewusst nicht auf Auflösung an sich optimiert, sondern für die Nachbildung der Abbildungseigenschaften des Lithographiescanners. Auf diese Weise kann AIMS quantifizieren, wie eine Struktur im Scanner gedruckt wird, und insbesondere, ob ein Fehler die Produktion beeinträchtigt und eine Fehlerbehebung erfolgreich ist.

Abgesehen von der Feststellung, d. h. der Inspektion, von Mängeln oder Unvollkommenheiten ist die Überprüfung der festgestellten Mängel von Bedeutung. Es gibt zwei Stufen bei solchen Überprüfungen der lithografischen Qualität von EUV-Masken:

1. Bewerten der gefundenen Defektkandidaten auf ihre Relevanz für den lithographischen Druckprozess und

2. Beheben gefundener Defekte, falls erforderlich. Der Prozess läuft also wie folgt ab:

a. Überprüfen mit einem auf die Scannerauflösung abgestimmten aktinischen Werkzeug, ob der bei der Inspektion festgestellte Fehler oder die festgestellte Unvollkommenheit tatsächlich als Fehler im lithographischen Prozess gedruckt wird.
b. Wird ein Defekt als "abdruckend" erkannt, erfolgt eine Reparatur durch weitere Maßnahmen.
c. Vor der Verwendung der Maske im lithographischen Prozess muss unbedingt überprüft werden, ob die Reparatur erfolgreich war - d. h., dass kein Fehler gedruckt wurde an der Stelle des Fehlers vor der Reparatur.

Über diese Werkzeuge hinaus müssen die Defekte und Strukturen mit hoher Auflösung betrachtet werden, um die Ursachen für die Defekte zu analysieren und ihre Natur besser zu verstehen. Für viele Anwendungen ist im Gegensatz zur AIMS-Prüfung eine hochauflösende Untersuchung von größerer Bedeutung als die Frage des "Druckens". Andererseits ist der AIMS-Prüfprozess für die Wertschöpfungskette des lithographischen Prozesses von außerordentlich hoher Bedeutung.

Im Gegensatz dazu muss ein hochauflösendes Überprüfungsmikroskop - das wissenschaftlich oder laborrelevant ist - wesentlich kostengünstiger sein und darüber hinaus eine hohe Flexibilität insbesondere in Bezug auf Vergrößerung, Auflösung und Beleuchtung besitzen.

Erforderlich für die Industrie und ihre Lieferkette ist ein eigenständiges Maskenbild-Mikroskop, das eine hohe räumliche Auflösung von fast 20 nm sowie eine hohe Flexibilität hinsichtlich der räumlichen Auflösung und anderer optischer Abbildungseigenschaften bietet. Typische akzeptable Belichtungszeiten für Einzelbilder mit dieser hohen Auflösung liegen im Bereich von 10 Sekunden, um "Durchfokussierungsserien" von 10-20 Einzelbildern pro Spot und etwa 5-10 Serien pro Stunde zu erzielen.

Die folgende Tabelle zeigt verfügbare Inspektionsgeräte mit ihren Eigenschaften.

|  | Flexibilität (FZP) | Laborquelle | Spektralfilter | Durchsatz |
|---|---|---|---|---|
| AIMS (ZEISS) | Nein: ML-Spiegel | Ja: Xe-GDP-Quelle | nicht notwendig | niedrig |
| SHARP (CXRO) | Ja | Nein: Speicherring | Monochromator | durchschnittl. |
| Perera US6738135 | Ja | Ja: Xe-GDP-Quelle | nicht erwähnt | sehr niedrig |

EUV-AIMS von ZEISS

Für den Überprüfungsprozess, ob festgestellte Defekte oder Strukturmängel den lithografischen Prozess wirklich beeinträchtigen und ob solche Druckfehler erfolgreich repariert wurden, wird ein spezielles Stand-Alone-Tool namens "Aktinisches Luftbildmikroskop (aAIMS)" von der Carl Zeiss SMT GmbH gelistet und vertrieben. Das besondere Merkmal dieses Mikroskops ist, dass die Druckausführung des lithographischen Scanners nachgebildet wird - d.h. die numerische Apertur (NA) an der Maske entspricht der NA im Scanner. Es wird auf AIMS™ EUV verwiesen.

In der US 6,894,837 B2 die auf der Priorität der DE 103 19 269 A1 basiert, wird die Verwendung von Fresnel-Zonenplatten wie folgt verworfen:
"US-Pat.-Nrn. 5,222,113; 5,311,565; 5 177 774 und EPO 459 833 zeigen Röntgenmikroskope, bei denen in der Projektionsoptik Zonenplatten zur Abbildung vorgesehen sind.... Der Nachteil bei der Verwendung von Fresnel-Zonenplatten in den Abbildungssystemen mit mehreren optischen Elementen im Bereich der Röntgenstrahlung besteht darin, dass Fresnel-Zonenplatten durchlässige Bauteile sind, die aufgrund der schlechten Transmission für Röntgenstrahlung zu großen Lichtverlusten führen."

Die US-Patente US 6 469 827 und US 5 022 064 beschreiben die Verwendung von diffraktiven (beugenden) Elementen zur spektralen Selektion von Röntgenstrahlung durch Beugung. In diesen beiden Patenten werden diffraktive Elemente jedoch nur zur spektralen Trennung und Auswahl von Röntgenstrahlung und nicht zur Korrektur oder Verbesserung der Abbildungseigenschaften verwendet.

Die Verwendung eines diffraktiven Elements mit lichtbrechungsverstärkender und achromatisierender Wirkung für ein Objektiv, insbesondere ein Mikroskopobjektiv, ist in der DE-OS 101 30 212 beschrieben. Ein derartiges Objektiv kann jedoch wegen der geringen Transmission der optischen Elemente nicht für EUV-Strahlung eingesetzt werden. Da EUV-Strahlung im Gegensatz zu UV-Strahlung in nahezu allen Materialien sehr stark absorbiert wird, ist der Einsatz transmissionsbasierter optischer Komponenten nicht sinnvoll, es sei, dass die optische Weglänge deutlich unter einem Mikrometer liegt.

Die US 6 738 135 B1 offenbart ein System zur Inspektion von Lithographiemasken unter Verwendung einer Laserquelle zur Erzeugung eines kohärenten elektromagnetischen Strahlungsimpulses, bei dem der Impuls auf ein Target geleitet wird, das ein Plasma erzeugt, dessen Strahlungsemission zu einem extremen ultravioletten (EUV) Strahl kollimiert wird. Der EUV-Strahl wird durch eine Öffnung geleitet, um eine Querschnittsfläche des Strahls auf einer Lithographiemaske zu definieren. Eine Transmissionszonenplatte löst das von der Lithographiemaske reflektierte Bild auf und leitet das Bild zur Analyse an einen Detektor weiter.

SHARP von CXRO (httpds:/sharp.lbl.gov/sharp/why-sharp/)

Ein ähnliches Werkzeug für die frühe Forschung in Richtung aktinische Schaltungsdruck-Prüfung wurde vom CXRO (Center of X-Ray Optics, Berkeley, USA) als realisiert und unter dem Namen "SHARP" veröffentlicht. SHARP ist ein aktinisches, Extrem Ultraviolett-Mikroskop (EUV) für die Photomaskenforschung.

SHARP verwendet EUV-Strahlung mit einer kleinen Winkeldivergenz, die von einem Synchrotron-Speicherring mit Ablenkmagnet-Strahlrohr emittiert wird. Diese spektral breitbandige Synchrotronstrahlung wird durch einen abstimmbaren Monochromator auf eine kleine spektrale Bandbreite von $\lambda/\Delta\lambda$ > 1000 um 13,5 nm gefiltert. Der Strahl wird - unter anderem räumlich abgestimmt - auf das Objekt gebracht. EUV passiert ein Loch in einer winzigen Membran in der Nähe des Objekts, um die Oberfläche der Maske in einem kleinen Bereich zu beleuchten.

Fresnel-Zonenplattenlinsen bilden das vom Objekt reflektierte EUV ab und erzeugen ein vergrößertes Bild, das als stark vergrößertes Bild beugungsbegrenzt auf eine EUVempfindliche, rückseitenbelichtete CCD-Kamera projiziert wird.

Die Zonenplatten werden mit Elektronenstrahllithographie in gemustertem Gold auf einer Siliziumnitridmembran hergestellt. Die Linsen sind nur etwa 100 $\mu$m breit, vergleichbar mit der Breite eines einzelnen menschlichen Haares. Für die verschiedenen Linsen in SHARP variieren die Brennweiten der Zonenplatten von 1,5 mm bis 275 $\mu$m, sind also sehr nahe an der Maskenoberfläche, berühren diese jedoch nicht.

SHARP zeichnet sich durch die Verwendung von Fresnel-Zonenplatten-Optiken und in der Folge durch eine hohe Flexibilität im Beleuchtungsprozess aus. Hunderte von durch den Benutzer auswählbaren Zonenplatten sind in SHARP installiert: Mit dem SHARP-Maskentisch können Messungen auf der gesamten Maskenoberfläche an leeren (Maskenrohlingen) oder an gemusterten Photomasken durchgeführt werden. Mit der Option zum Umschalten zwischen verschiedenen Zonenplatten ermöglicht die nanoskopische Bildgebung mit Vergrößerungen von 100 bis über 1000 auf der Maskenoberfläche eine Auflösung von 22 nm im Halbschritt- (Halbperioden-) Modus unter Verwendung einer handelsüblichen, rückseitenbelichteten Slow-Scan-CCD-Kamera mit Pixeln von 13,5 $\mu$m Kantenlänge. Die Einzelbild-Aufnahmezeit von SHARP beträgt im hochqualitativen Aufnahmemodus in der Regel 5 bis 8 Sekunden. Beim Fokussieren mit einer Schrittgröße von 0,4 $\mu$m oder mehr werden von Nutzern typischerweise 11 bis 21 Schritte aufgezeichnet, sodass SHARP - abhängig vom Testplan - ungefähr acht Bildserien pro Stunde aufzeichnen kann.

Im Allgemeinen ist das CXRO-SHARP das Rohmodell eines hochflexiblen Maskenbild-Mikroskops, wie es von der Industrie benötigt wird. Da aber SHARP untrennbar an ein Synchrotron-Speicherring-Strahlrohr (Speicherring des Lawrence Berkeley National Lab) gebunden ist, wird es äußerst schwierig als Einzelgerät (Stand-Alone-Device) in Form eines Labormikroskops zu realisieren sein.

Die US 6 894 837 beschreibt ein Bildgebungssystem für ein Mikroskop auf der Basis von Extrem-Ultraviolettstrahlung (EUV) unter Verwendung einer abbildenden Reflexionsoptik mit einem reflektierend-diffraktiven optischen Element, bei dem es sich um ein Wechselschicht-Spiegelobjektiv (multi-layer optics) handelt. Nachteilig sind, wie oben beschrieben, die hohen Kosten und die großen Abmessungen eines einzelnen Objektivs, sodass die Integration verschiedener Optiken mit unterschiedlichen Abbildungseigenschaften nicht möglich ist.

Obwohl der mit dem vorgestellten System vorgenommene Überprüfungsprozess selbst schnell ist und die Ergebnisse durch schnelle Algorithmen in Echtzeit ermittelt werden können, ist eine detaillierte Prüfung einer gesamten Maske in voller Größe in einem realistischen Zeitrahmen nicht möglich. Das EUV-Mikroskop kann daher nur zur Stichprobenprüfung verwendet werden und erfordert ein zusätzliches Inspektions-Tool zur Identifizierung von interessierenden Bereichen der Photomaske oder gute a priori Kenntnisse über einen zu überprüfenden Bereich. Die DE 10 2007 041939 A1 offenbart ein EUV-Mikroskop, das eine Zonenplatte verwendet und Mittel zur Unterdrückung von Strahlung außerhalb des EUV Bereichs sowie zur Breitband-Spektralfilterung aufweist.

Röntgenmikroskope

Zur Untersuchung biologischer Objekte wurden in der Vergangenheit auch Mikroskope mit weicher Röntgenstrahlung im Spektralbereich des Wasserfensters (2,5 nm < λ < 4,2 nm) realisiert. Diese Systeme sind jedoch aufgrund ihrer Wellenlänge nicht für die Inspektion von EUV-Masken im Reflexionsmodus geeignet. Es wird auf die US 5 177 774 A verwiesen, die ein derartiges Mikroskop für weiche Röntgenstrahlung beschreibt.

EUV-Quellen (Plasma als EUV-Strahler)

EUV-Strahlung entsteht, wenn Materie auf Temperaturen um 200.000 K erhitzt wird, was zur Folge hat, dass das Material verdampft und sich zu einem Plasmazustand erhitzt. Alle in einen Plasmazustand gebrachten Elemente sind hoch ionisiert (z.B. Xenon 12-14fach) und emittieren - neben IR, sichtbarem Licht, UV und VUV) auch Strahlung im EUV-Spektralbereich (häufig auch breiter mit XUV-Bereich von 2-20 nm benannt). Die Emissionsspektren dieser hochionisierten Elemente werden jedoch durch ihre atomare Energieniveauverteilung bestimmt - eine aus der individuellen Natur des Elements resultierende Invariante jedes Ions.

In der EUV-Lithographie mit Zielwellenlängen um 13,5 nm - definiert befördert durch die Tatsache, dass in diesem Spektralbereich eine ausgereifte Technologie zur Herstellung hocheffizienter Wechselschichtspiegelsysteme (multi-layer mirror) verfügbar war - wurden sehr früh drei Hauptkandidaten identifiziert, d. h. Lithium, Xenon und Zinn. Davon wurde Lithium frühzeitig verworfen, da festgestellt wurde, dass Breitbandemitter wie Xenon und Zinn viel höhere Konversionseffizienzen in die für EUVL typische spektrale Bandbreite von 2 bis 4% um die Zielwellenlänge 13,5 nm erreichen. Später wurde Zinn das derzeit verwendete Targetmaterial, da sein Emissionsspektrum einen Emissionsspitzenwert bei etwa 13,5 nm aufweist - was eine höhere spektrale und somit EUVL-verwertbare Umwandlungseffizienz ergibt. Prinzipiell gibt es zwei Möglichkeiten, ein solches EUV-emittierendes Plasma zu erzeugen: durch Bestrahlen des Targetmaterials mit einem intensiven Laserstrahl oder durch elektrische Entladungen mit hoher Stromdichte.

Lasererzeugte Plasmen

EUV-emittierendes Plasma (Laser Produced Plasma: LPP) wird immer dann erzeugt, wenn intensive Laserpulse auf ein Targetoberfläche mit Intensitäten von etwa $10^{11}$ W/cm$^2$ fokussiert werden. Im Allgemeinen bevorzugt ein LPP Targetmaterialien, die in einer Ultrahochvakuumumgebung mit nicht zu hohem Dampfdruck fest oder flüssig sind. Da dieses bei Zinn gegeben ist und zudem eine hohe Umwandlungseffizienz in EUV-verwertbare Photonen aufweist, ist Zinn-LPP eine heute bevorzugt in EUV-Scannern verwendete Strahlungsquelle.

Für Metrologieanwendungen, die nicht so empfindlich auf die Umwandlungseffizienz reagieren, aber für spektroskopische Untersuchungen eine noch breitbandigere kontinuierliche Emission wünschen, sind z.B. goldbeschichtete Stahloberflächen bevorzugt.

Außerdem wurde auch Lithium-LPP speziell untersucht, weil es eine für EUV hauptsächlich interessierende Emissionslinie bei 13,5 nm erzeugt. Da Lithium-LPP jedoch aufgrund der Sättigung des Strahlungstransports eine relativ geringe Umwandlungseffizienz aufweist, die z.B. für Spektralanwendungen nicht breit genug ist, wird Lithiumplasma praktisch auf keinem technischen Gebiet verwendet. Außerdem hat Lithium aufgrund einer chemisch aggressiven Natur, die bei Kontakt mit Sauerstoff oder Wasser schnell zur Oxidation führt, hohe Anforderungen an seine Handhabung.

Gasentladungsquellen

Alternativ kann EUV-Strahlung effektiv aus Hochstrom-Gasentladungs-Funkenplasma (Gasentladungs-erzeugtes Plasma: DPP) erzeugt werden. Die typische Schwelle der EUV-Erzeugung liegt bei einem Funkenstrom von 15.000 bis 25.000 A. Eine Gasentladungs-EUV-Quelle wird am einfachsten realisiert, wenn die Entladung in einer Gasatmosphäre von etwa 0,01 bis 1 mbar eines gasförmigen Targets gezündet wird. Daher wurden in den frühen Tagen der EUVL Xenon-DPP-Quellen für messtechnische Anwendungen und kompakte Labortools untersucht und verwendet. Im Vergleich zu DPP zeichnet sich LPP durch seine Brillanz aus, d.h. die Emissionsausbeute pro emittierende Fläche der Quelle. Auf der anderen Seite sind DPP einfacher in der Handhabung des Targetmaterials (hier Gas) und den Gesamtkosten und können bei gleicher netzseitiger Eingangsleistung einen höheren EUV-Fluss erzeugen. Eine derartige auf die Netzeingangsleistung bezogene Gesamteffizienz des DPP ist gegenüber LPP höher, da anstelle der Umwandlung von Elektrizität zu Laser- zu Plasmaenergie bei LPP beim DPP eine direkte Umwandlung von Elektrizität in Plasmaanregung verwendet wird.

Hybridquellen

Als die EUV-Emission von Zinn (oder eines anderen festen Targets) in Verbindung mit dem hohen Wirkungsgrad eines DPP angestrebt wurde, löste dies die Entwicklung der Hybridlösung einer "laserunterstützten Gasentladungs-plasma-EUV-Quelle" aus. In diesem Schema erzeugt ein Laser verdampftes Zinn, das dann die Atmosphäre ist, in der eine elektrische Gasentladung die DPP-Emission erzeugt.

Alle bekannten Lösungen weisen Nachteile auf, wenn es darum geht, flexible eigenständige Werkzeuge für einzelne Industrie- und F&E-Labors mit einer hohen Auflösung von bis zu 10 nm und einem akzeptablen Durchsatz von mehr als z.B. fünf Bildern pro Minute.

Zonen-Platte versus reflektierende, mehrschichtig beschichtete Optik

Grundsätzlich ermöglichen sowohl Zonenplatten- als auch Vielschichtoptiken eine beugungsbegrenzte Auflösung. Es gibt nur zwei Variablen der optischen Abbildung, die die Auflösung bestimmen, die durch die minimale unterscheidbare Merkmalsgröße $\Delta x_{min}$ gekennzeichnet ist:
Die beugungsbegrenzte Auflösung wurde von Ernst Abbe als $\Delta x_{min} = \lambda/NA$ gefunden, wobei

$\Delta x$ die auflösbare Struktur,
$\lambda$ die Wellenlänge der Strahlung, die für die Anwendung verwendet wird (hier die EUVL-Wellenlänge von 13,5 nm) und
NA die numerische Apertur der Abbildungsoptik sind.

Für Mikroskope mit Kondensoren wurde dieser Wert nach tiefer gehender Analyse auf die Rayleigh-Grenze von $\Delta x_{min} = 0{,}61\ \lambda/NA$ beschränkt.

Für beide Arten von Linsen entspricht die numerische Apertur in der Mikroskopie in etwa dem Verhältnis zwischen Linsenradius und Brennweite. Für Fresnel-Zonenplatten kann jedoch gezeigt werden, dass die Apertur derart mit der Breite der äußersten Zone verknüpft ist, dass letztlich diese die Abbe-Auflösung bestimmt.

Um konstruktive Interferenzen im Fokus zu erhalten, sollten die Zonen in Radien, in denen (die folgenden Formeln sind von http://zoneplate.lbl.gov/theory), von undurchsichtig zu transparent wechseln

$$R_n = \sqrt{n\lambda f + \frac{1}{4} n^2 \lambda^2}$$

Dabei ist n die ganzzahlige Zahl als n-te Zone von der Mitte, $\lambda$ die Wellenlänge des Lichts, auf das die Zonenplatte fokussieren soll, und f der Abstand von der Mitte der Zonenplatte zum Fokus. Wenn die Zonenplatte im Vergleich zur Brennweite klein ist, kann dies angenähert werden als

$$R_n = \sqrt{n\lambda f}$$

Wie bei allen Objektiven wird die gebeugte, begrenzte Auflösung durch die Wellenlänge und das Verhältnis zwischen Brennweite und Linsendurchmesser (w) bestimmt, was gleichbedeutend mit der numerischen Apertur ist:

$$w = \frac{\lambda}{2NA}$$

Für Zonenplatten mit vielen Zonen (N) können Sie die Entfernung zum Fokus berechnen, wenn Sie nur den Radius der äußersten Zone $R_N$ und ihre Breite $\Delta R_N$ kennen:

$$f = \frac{2 R_N \Delta R_N}{\lambda}$$

Für Zonenplatten kann gezeigt werden, dass die Breite der äußersten Zone der Wellenlänge geteilt durch das Zweifache der NA entspricht

$$\Delta R_N = \frac{\lambda}{2\,NA}$$

Setzt man diese Gleichung in das Auflösungskriterium ein, kann gezeigt werden, dass in der großen Fokuslängengrenze die maximal mögliche Auflösung einer Zonenplatte abhängig ist von der kleinsten Zonenbreite $\Delta R_N$

$$\frac{\Delta\lambda}{\lambda} \leq \frac{\lambda/(NA)^2}{f} \cdot \frac{1}{N}$$

Daher ist das kleinste Objekt, das sie abbilden können, $\Delta x_{min}$, dadurch begrenzt, wie klein sie ihre Zonen zuverlässig erstellen können.

Im Allgemeinen erreichen Fresnel-Zonenplatten eine beugungsbegrenzte Auflösung nur mit monochromatischer Strahlung, da die Brennweite eine Funktion der

Wellenlänge der verwendeten Strahlung ist. Beugungsbegrenzte Auflösung wird also dann erreicht, wenn diese chromatische Unschärfe des Bildes kleiner ist als die von der numerischen Apertur erwartete Auflösung. Daraus folgt, dass die akzeptierbare Bandbreite für eine für die Auflösung erforderliche numerische Apertur von der Anzahl der Brennweite bzw. Anzahl der Zonenringe - also dem Durchmesser der Zonenplatte abhängt. Dies zeigt sich deutlich an dem Kriterium für die spektrale Bandbreite, die sich aus den oben aufgeführten Formeln für Zonenplatten ergibt

$$\frac{\Delta\lambda}{\lambda} \leq \frac{\lambda/(NA)^2}{f} \cdot \frac{1}{N},$$

was so interpretiert werden kann, je schmaler die Bandbreite $\Delta\lambda/\lambda$ der verwendeten Strahlung ist, desto größer kann die Brennweite und auch der Durchmesser der Zonenplatte ($R_N$) werden, was mit einer Vergrößerung der Anzahl der Zonen (N) einhergeht.

Folglich können Brennweite und Sichtfeld wachsen, je schmaler die Bandbreite der verwendeten Strahlung wird. Ziel ist es sicherlich, die Brennweite in den Bereich von größer als 100 $\mu$m (wegen der praktischen Umsatzbarkeit) und ein Sichtfeld in der Größenordnung von ca. 20 Mikrometern zu maximieren.

Die Größe des idealen Gesichtsfeldes ergibt sich aus der Größe handelsüblicher CCD Detektoren (27*27 mm$^2$), deren Pixelgröße von 13.5 $\mu$m und der damit ca. 1000-fach vergrößerten Abbildung.

In der folgenden Tabelle werden die Eigenschaften von Zonenplatten und Multilayer-Spiegelsysteme verglichen.

| | Zone Plates | Multilayer-Spiegelsysteme |
|---|---|---|
| beste Auflösung $\Delta x_{min}$ | $\Delta x_{min} = c\,\lambda/NA \approx \Delta R_N$ | $\Delta x_{min} = c\,\lambda/NA$ |
| NA | beeinflusst durch die Breite der äußersten Zone | Durchmesser der Optik relativ zur Fokuslänge |
| Fokuslänge | für gegebene $\Delta R_N$ und $\lambda$ nur durch Anzahl der Ringe | Oberflächenkrümmung |
| beugungsbegrenzte Abbildung | beschränkt durch Farbfehler | Oberflächenfehler u. Genauigkeit d. Spiegelhalterung; bessere Qualität mit Mehrlinsensvstemen (N Spiegel) |
| Abbildungseffizienz | Amplitude $\eta \approx 10\%$ Phase: $\eta \approx 20\%$ | Mo/Si-Vielschichtsystem: $\eta \approx (60\%)^N$ |
| Kosten pro Objektiv | ca. 1-10 k€ | einige 100 k€ |

Strahlrohrbasierte Synchrotronstrahlungsquellen

Die Strahlrohr-Installation an Synchrotronspeicherringen oder -insertionsgeräten erzeugt Synchrotronstrahlung mit hoher spektraler Brillanz, die aufgrund ihrer hohen spektralen Brillanz ideal geeignet ist, eine effektive räumliche und spektrale Filterung zu erreichen, um die Auflösung mit einem akzeptablen Durchsatz zu erreichen, sodass Lösungen wie SHARP eine hervorragende räumliche Auflösung und eine extreme Flexibilität der optischen Eigenschaften bieten, die z.B. Änderungen der Vergrößerung oder Umschaltungen zwischen konventionellen und phasenverschobenen Zonenplattenoptiken gestatten. Ein solches Maskenreflexionsmikroskop benötigt daher nur wenige Sekunden für die Aufnahme eines Bildes und ermöglicht 10 bis 20 Durchgangsfokussequenzen an etwa 10 Punkten pro Stunde.

In der SHARP-Installation wird dies durch spektrale Filterung des Breitband-Synchrotrons $\lambda/\Delta\lambda > 1$ Strahlung auf Schmalband ($\lambda/\Delta\lambda > 1000$) mit einem Monochromator erreicht. Ein derart intensiver Schmalbandstrahl ermöglicht die Verwendung von Fresnel-Zonenplatten für das Mikroskop bei praktikablen Linse zu Objektabständen und Bildfeldgröße wie oben gefordert, während Beleuchtung und Strahlformung mit breitbandigen ($\lambda/\Delta\lambda < 50$) reflektierenden Vielschichtspiegeln bereitgestellt werden können.

Ähnliche Auflösungen werden mit reflektierenden optischen Systemen erzielt, die aber - da diese eine extrem hohe Präzision der Oberflächenmerkmale erfordern - infolge von Nanodünnfilmbeschichtung, Ausrichtung und Stabilität extrem teuer und recht voluminös sind.

Nachteile und Probleme des Standes der Technik

◦ Obwohl die Synchrotron-basierte EUV-Mikroskopie besser und flexibler sein kann, ist sie jedoch nur in dezentralen Großanlagen und Forschungseinrichtungen als Strahlungsquelle realisierbar.

◦ Arbeitsabstand und Sichtfeld hängen entscheidend von der Bandbreite der verwendeten Strahlung ab.

◦ Wenn man eine Auflösung von 20 $\mu$m mit einer Xenon- oder Zinnquelle mit einer mehrschichtigen gefilterten Bandbreite von 2% anstrebt - was immer die effektivste und wirtschaftlichste Lösung ist - müsste der Arbeitsabstand im Bereich von 6 $\mu$m liegen, was ziemlich aufwändig für die Steuerung und Stabilität des Fokus ist. Das Sichtfeld würde einen Durchmesser von unter 100 nm haben.

◦ Wenn die Bandbreite z.B. mit kommerziell verfügbaren EUV Gittern (z.B. von Hitachi) oder speziellen vielschichtig beschichteten Filtern auf 0,2% gefiltert wird, gibt es spezielle Nachteile:

- mindestens eine Größenordnung des 2%-Bandbreitenflusses von Xenon oder Zinn geht verloren,
- die Spektralfilterung erfordert spezielle Komponenten und hat bestenfalls einen Wirkungsgrad von 15%,
- der Arbeitsabstand erhöht sich auf ca. 60 $\mu$m - noch relativ klein
- das Sichtfeld hätte einen Durchmesser von ca. 700 nm.

◦ Das Filtern der breitbandigen Xenon- oder Zinnemission auf $\lambda/\Delta\lambda$ = 1500 (sehr ähnlich zu im SHARP benutzten Werten) der relativen Bandbreite würde zwar

- die Verwendung eines Arbeitsabstands in der Größenordnung von 175 $\mu$m und die Erzielung eines Sichtfelds im Bereich von 20 $\mu$m ermöglichen, aber
- bei einem geschätzten Filterverlust von 85% zu einem Abfall der spektralen Umwandlungseffizienz auf ca. 3% führen, sodass der Strahlungsfluss ca. 0,6% der gesamten 2%-Bandbreite in einem EUV-Scanner ausmachen würde.

Die Erfindung hat die Aufgabe, Defekte und Strukturen auf Photomasken für die Extrem-Ultraviolett-Lithographie (EUVL) mit hoher räumlicher Auflösung im Bereich < 50 nm flexibel, effektiv und schnell mit einer kompakten Laborquelle zu überprüfen.

Die Aufgabe wird gemäß den Merkmalen des Anspruchs 1 gelöst.

Vorteilhafte Ausgestaltungen sind in den untergeordneten Ansprüchen beschrieben.

Erfindungsgemäß wird das oben genannte technische Problem gelöst, indem eine kompakte, eigenständige ("laborfähige") EUV-Strahlungsquelle verwendet wird, die mit ihrer natürlichen Spektralverteilung IR- und EUV-Strahlung emittiert, und ein optisches System mit z.B. optischen Vielschichtfilteroptik ("Multilayer Optics") zur Bestrahlung des Objekts und Fresnel-Zonenplatten (FZPs) zur Erzeugung hochaufgelöster Bilder (< 100 nm Auflösung). Da diese FZPs in ihrer Abbildung stark achromatisch sind, muss die verwendete Strahlung spektral sehr schmalbandig sein. Schmalband bedeutet, dass die spektrale Bandbreite ($\Delta\lambda$) der Strahlung im Strahl kleiner ist als die Wellenlänge geteilt durch einen Faktor $N_{bw}$, der größer als 500, vorzugsweise gleich 1000 oder größer ist. Die Bandbreite solcher Strahlen wird daher häufig als $\lambda/\Delta\lambda < N_{bw}$ bezeichnet.

Da alle kompakten "laborfähigen" EUV-Strahlungsquellen Breitbandspektren in der Regel von einer minimalen Wellenlänge (etwa 5nm für EUV-Quellen) bis in das tiefe Infrarot emittieren, sind einige Mittel zum Filtern der spektralen Emissionsverteilung ($\lambda/\Delta\lambda > N_{bw}$) in den schmalbandigen EUV-Strahl mit der interessierende Wellenlänge $\lambda_{CWL}$ einzusetzen. Bei EUV-Masken für die Lithographie beträgt diese Wellenlänge in der Regel $\lambda_{CWL} = \lambda_{EUVL} \approx (13{,}5 \pm 0{,}2)$ nm, abhängig vom Design der lithographischen Scanner.

Dieser schmalbandige EUV-Strahl wird gebündelt auf das Objekt gerichtet, das als EUV-Photomaske in reflektierender Geometrie zu messen ist. Die vom Objekt reflektierte EUV-Strahlung wird mit Objektiven vom Fresnel-Zonenplatten-Typ vergrößert, um ein Bild zu erzeugen, das mit einem zweidimensionalen Bilddetektor, der auf EUV-Strahlung empfindlich ist, aufgenommen wird.

Gemäß der Erfindung wird vorgeschlagen, eine Linienemission mit großer Helligkeit von Elementen mit niedriger Ordnungszahl Z zu verwenden, die von Natur aus bereits schmalbandige Linienstrahlung emittieren ($\lambda/\Delta\lambda > 1.500$). Wenn diese mit einem Filter mit niedriger Bandbreite (Breitbandfilter: $\lambda/\Delta\lambda < 50$) kombiniert werden (z. B. durch Vielschichtspiegelreflexion), wird eine geeigneten spektralen Schmalbandverteilung mit geringem Filteraufwand erreicht.

Im Allgemeinen enthalten die Spektren, die aus Elementen mit niedrigen Atomzahlen bzw. Ordnungszahlen Z, wie z. B. He, Li, B, Be, ... bis etwa Argon (Z = 18) erzeugt werden, meistens deutlich separierte, d.h. freistehende Emissionslinien. Bevorzugt werden Elemente mit Ordnungszahlen $Z \leq 10$ gewählt, wobei insbesondere Elemente mit Ordnungszahlen von Z = 2 ... 8 den Vorrang erhalten, weil dort die freistehenden Emissionslinien zusätzlich einen größeren Abstand aufweisen, der die spektrale Filterung wesentlich vereinfacht.

Emissionsspektren von Elementen mit hohen Atomzahlen (z. B. Gold oder Blei) emittieren eine Vielzahl von nahe beieinanderliegenden einzelnen Linien, die sich so stark überlagern, dass über ein sehr breites Spektralband (z. B. 8 nm - 20 nm) ein nahezu kontinuierliches Spektrum entsteht, das einen erheblichen Aufwand für die Schmalbandfilterung erfordert.

Speziell wurde Lithium-LPP untersucht, da es für EUV hauptsächlich eine dominierende Emissionslinie bei 13,5 nm erzeugt, die eine spektrale Bandbreite von $\Delta\lambda \leq 0{,}009$ nm aufweist, was einer relativen Bandbreite von $\lambda/\Delta\lambda$ = 1500 entspricht, und somit bestens geeignet ist für eine mit SHARP vergleichbare Schmalbandigkeit. Ein solcher Ansatz könnte einen gezielten Durchsatz von weniger als 5 Sekunden pro Bild mit einer recht kompakten Laborquelle erzielen, wenn er mit dem laserproduzierten Plasmakonzept erzeugt wird, das sich auszeichnet durch hohe Helligkeit im Allgemeinen.

Dieser Ansatz ist weitaus einfacher und effektiver (mehr als eine Größenordnung) als der Stand der Technik, der quasi breitbandig ($\lambda/\Delta\lambda$ < 10) die Emission einer Hochleistungslaborquelle (z. B. auf Basis von Zinn oder Xenon) auf die schmale Bandbreite filtert durch Verwendung von Gittern, wie z. B. in Monochromatoren. Dieses Konzept ist sicherlich sehr erfolgreich, wenn Synchrotronstrahlungsquellen durch Strahlrohre oder Einfügevorrichtungen mit hoher spektraler Helligkeit (genauer: Brillanz, d.h. Leistung pro Fläche und Raumwinkel) genutzt werden, aber eher nicht geeignet, ein von der Halbleiterindustrie gewünschtes eigenständiges Messwerkzeug für die EUVL-Zulieferkette zu betreiben.

Mit der vorliegenden Erfindung wird ein neues und nützliches System zur flexiblen hochauflösenden Überprüfung von Strukturen und Defekten auf EUV-Lithographie-Photomasken bereitgestellt, mit der bei hoher räumlicher Auflösung im Bereich < 50 nm flexibel, effektiv und schnell (d.h. mit hohem Durchsatz) Defekte und Strukturen auf Photomasken für die Extrem-Ultraviolett-Lithographie (EUVL) mit einer kompakten plasma-basierten "labortauglichen" EUV-Strahlungsquelle überprüft werden können.

Im Folgenden wird die Erfindung anhand von Ausführungsbeispielen näher erläutert Die Zeichnungen zeigen:

Fig. 1. eine schematische Ansicht des Systems der vorliegenden Erfindung.

Fig. 2: zeigt am Beispiel von Lithium die Emission eines Plasma-Linienemitters mit isolierten Emissionslinien, die für die Erfindung genutzt werden,

Fig. 3: die Lyman-alpha ($Ly_\alpha$)-Emissionslinie bei 13,5 nm, aufgelöst mit einem Spektrographen von $\lambda/\Delta\lambda$ < 700 in zweiter Ordnung,

Fig. 4 Schema eines kompletten EUV-Reflexionsmikroskops unter Verwendung der vorgeschlagenen Erfindung,

Fig. 5 Prinzipschema eines EUV-Reflexionsmikroskops unter Einsatz der kompakten erfindungsgemäßen EUV-Strahlungsquelle mit einer Plasmaquelle, dessen Emitterelement eine dominante freistehende Emissionslinie aufweist und deshalb mit einfachen Filtermitteln aus Vielschichtfilterspiegeln und einem Bandpass (SPF) den Einsatz eines Fresnel-Zonenplattenobjektivs im EUV-Mikroskop gestattet.

Fig. 6 Beispiel einer Zonenplatte mit 1,5 $\mu$m Durchmesser, hergestellt durch einer CXRO-Nanoschreibgruppe, wobei daneben abgebildete Strukturen von 20 nm bis 10 nm gezeigt sind,

Fig. 7 Schema einer Fresnel-Zonenplatte, die eine ebene Welle fokussiert,

Fig. 8 EUV-Emissionsspektrum von Sauerstoff mit zwei freistehenden Emissionslinien.

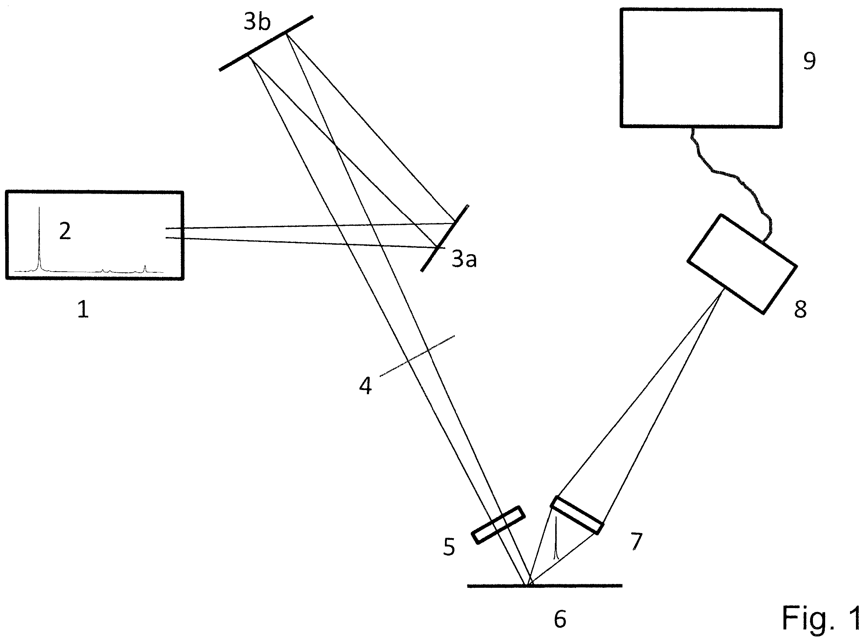

Fig. 1 zeigt das Schema einer möglichen Ausführung der Erfindung. Eine kompakte plasmabasierte EUV-Quelle 1, die - unter langwelligeren Strahlungsanteilen (im IR, VIS, UV-Bereich) - EUV-Strahlung im Spektralbereich von z.B. 12-20 nm mit hoher Intensität und Brillanz emittiert. Die spektrale Emission 2 dieser EUV-Quelle 1 ist hauptsächlich auf eine intensive freistehende Emissionslinie nahe der EUVL-Arbeitswellenlänge von 13,5 nm konzentriert.

Diese Emission 2 der EUV-Quelle 1 wird über ein oder mehrere mit Vielschichtfiltern beschichtete optische Elemente 3a, 3b, ... zum Objekt 6 geführt. Wesentlich ist, dass an beliebiger Stelle in diesem Strahlengang bis zum Objekt 6 ein spektral reines metallisches Dünnschichtfilter 4 als spektrales Bandpassfilter (SPF- spectral purity filter) angeordnet ist, das langwellige Strahlung abblockt. Beleuchtungs- und Abbildungseigenschaften können durch zusätzliche optische Elemente (nicht gezeichnet) im Strahlengang unterstützt werden. Beispiele dafür sind Reflexionsspiegel mit streifendem Lichteinfall oder ein Kondensorspiegel.

Die Strahlung wird dann von der Objektoberfläche 6 reflektiert und kann - da sie jetzt im Wesentlichen nur schmalbandige EUV-Strahlung um 13,5 nm enthält - mit einer Zonenplatte 7 von > 1 $\mu$m, vorzugsweise > 20 $\mu$m Durchmesser mit hoher Auflösung abgebildet werden.

Die Abstände der Zonenplatte 7 zum Objekt 6 sind so gewählt, dass ein vergrößertes Bild der Oberfläche des Objekts 6 auf das zweidimensionale EUV-Detektorarray 8 (z.B. ein rückseitenbelichtetes CCD, CMOS-Kamera, etc.) abgebildet wird. Die im Detektorarray 8 generierten Signale werden elektronisch an einen Computer 9 übertragen, der eine Bildanzeige gestattet und eine weitere Bildverarbeitung vornimmt.

Durch die Verwendung des Fresnel-Zonenplattenobjektivs im EUV-Prüfmikroskop wird auch die Forderung nach Flexibilität des optischen Abbildungsstrahlengangs erfüllt. Die einzige dazu alternative Lösung, die für die hochauflösende Abbildung von EUV-Strahlung bei etwa 13,5 nm verwendbar wäre, ist eine Spiegeloptik mit mindestens zwei (Schwarzschild-Objektiv-) Spiegelsubstraten, die mit Vielschicht-Reflexionsfiltern (z.B. alternierende Silizium- und Molybdänschichten) beschichtet sind. Solche Spiegelsysteme für eine hohe Auflösung erfordern aber die Herstellung von extrem präzisen Substraten geringer Rauigkeit und eine präzise Beschichtung von mehr als 30 typischerweise 7 nm dicken Schichtpaaren mit einer Dickengenauigkeit von besser als 0,05 nm. Darüber hinaus sind - für hohe Aperturen - die Schichten mit Dickengradient über den Spiegeln herzustellen.

Die erforderliche Implementierung von mehreren solchen Objektiven in ein Mikroskop, das dann sehr kostspielig und ziemlich voluminös wäre, kann nur durch die Erfindung mit dem Einsatz von Fresnel-Zonenplatten 7 vermieden werden.

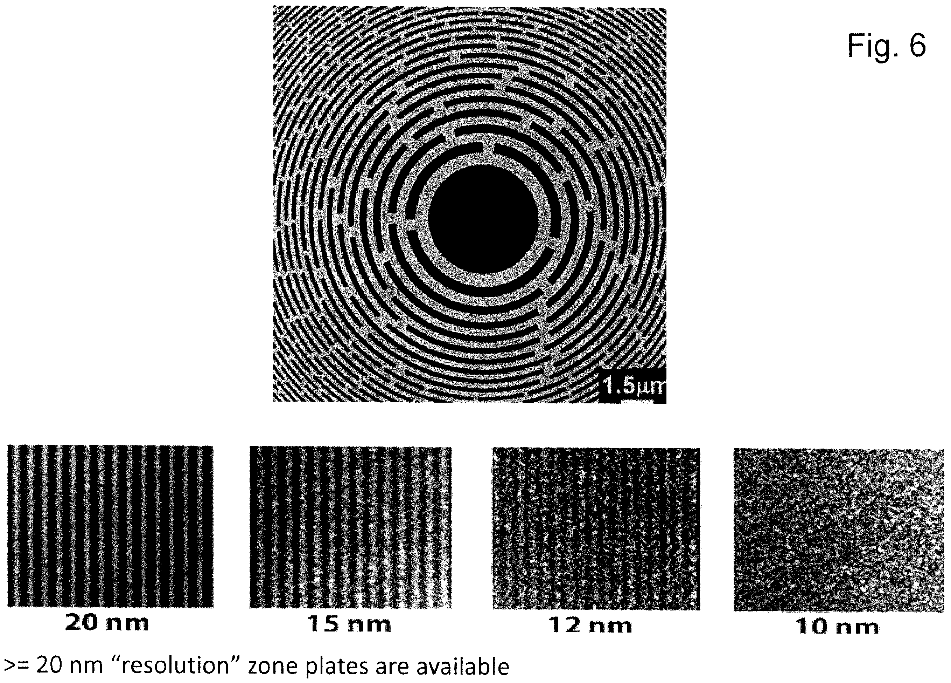

Bei den Fresnel-Zonenplattenobjektiven 7 hängt die erreichbare Auflösung $\Delta x_{min}$ direkt von der Breite der äußersten Zone $\Delta R_N$ ab. Weniger als 20 nm wurden nachgewiesen und sind verfügbar, wie es in Fig. 6 gezeigt ist.

Die Fresnel-Zonenplatte 7 kann durch einfaches Nano-Elektronenstrahlschreiben der gewünschten Strukturen und durch nanopräzises Ätzen der Absorber- oder Phasenverschiebungsstrukturen hergestellt werden. Eine einfache Zonenplatte 7 reicht für die hochauflösende Bildgebung aus. Da eine einzelne Zonenplatte 7 in der Regel einen Durchmesser von weniger als 1 mm und eine Höhe von weniger als 1 $\mu$m aufweist, ist es einfach, viele davon im selben Werkzeug mit einer implementierten Austauschmechanik vorzusehen. Ein solches Mehrzonenplattensystem wurde bereits realisiert.

In Fig. 6 ist ein Beispiel für die im erfindungsgemäßen System verwendete Zonenplatte 7 gezeigt. Die Zonenplatte ist mit 1,5 $\mu$m Durchmesser hergestellt mittels einer CXRO-Nanoschreibgruppe. Die daneben abgebildeten Streifenstrukturbilder weisen nach, dass bis zu 20 nm perfekte Strukturen erreicht werden, bei 15 nm und 12 nm noch Strukturen deutlich erkennbar sind, aber einen geringen Kontrast haben; und dass bei 10 nm vorerst die Grenze der Strukturerkennung liegt.

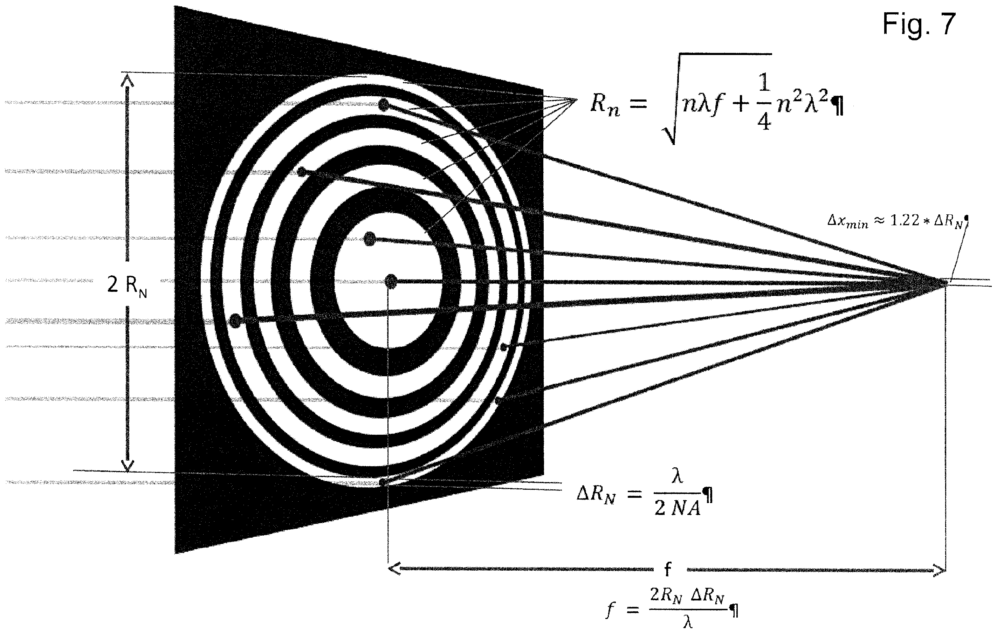

Fig. 7 zeigt ein konkretes Schema einer Fresnel-Zonenplatte 7, die eine ebene Welle fokussiert. Die theoretische Auflösung, die durch die Breite der äußersten Zone $\Delta R_N$ bestimmt wird, kann infolge chromatischer Fehler nur erhalten werden, wenn die Bandbreite der Strahlung, die $(\lambda/\Delta\lambda)$ beiträgt, kleiner als die Anzahl N der beteiligten Zonen $R_N$ ist.

Anwendung der Schmalbandstrahlung zur Bildgebung für eine beugungsbegrenzte Abbildung

Da die Fresnel-Zonenplattenoptiken 7 sehr anfällig gegenüber chromatischen Fehlern sind, d. h. da sie unterschiedliche Brennweiten f für unterschiedliche Wellenlängen $\lambda$ haben, wird die beste ("beugungsbegrenzte") Auflösung nur dann erreicht, wenn die Bandbreite der für den Abbildungsprozess verwendeten Wellenlängen, ausgedrückt als $(\lambda/\Delta\lambda)$, kleiner als die Anzahl N der Zonen $R_N$ in der Zonenplatte 7 ist. Das führt dazu, dass die Bedingung $(\lambda/\Delta\lambda) \leq N$ erfüllt sein muss.

Um die bestmögliche Lösung der Aufgabe der Erfindung zu erreichen, sollte das zur Abbildung verwendete Licht schmalbandig sein, vorzugsweise besser als $\lambda/\Delta\lambda = 1000$; vorzugsweise $\lambda/\Delta\lambda = 1500$-2000.

Aus praktischen Gründen ist es wichtig, eine Brennweite zu haben, die den Arbeitsabstand zwischen Objekt und Linse definiert. Die Brennweite muss groß genug sein, um eine Genauigkeit von etwa 1% für die beste Bildauflösung und ein Bildfeld zu erzielen, das etwa die Hälfte des Durchmessers $D_N$ der Zonenplatte 7 beträgt, damit brauchbare Bilder mit hoher Auflösung über einen angemessenen Bereich des Objekts 6 erreicht werden.

Wenn man bei diesen Überlegungen nur eine Bandbreite von $\lambda/\Delta\lambda = 500$ annimmt, beträgt die Brennweite in diesem Beispiel weniger als 50 $\mu$m und der Bildfelddurchmesser etwa 20 $\mu$m. Diese Werte sind sehr klein, um die weiteren technischen Aufgaben zu erfüllen, liegen jedoch im Rahmen der Machbarkeit. Noch größere Bandbreiten von z.B. $\lambda/\Delta\lambda = 50$, wie sie im lithografischen Scanprozess verwendet werden, ergeben eine Brennweite von f = 6 $\mu$m und Bildfelder von 2 $\mu$m auf dem Objekt - und wären somit nicht praktikabel und nicht zur Lösung der Aufgabe verwendbar. Folglich ist nur eine Lösung von Schmalbandstrahlung von $\lambda/\Delta\lambda > 500$, vorzugsweise > 1000, für die hochauflösende Bildgebung geeignet.

Die plasmabasierte EUV-Quelle 1 ist die Voraussetzung für ein eigenständiges Prüfwerkzeug, wie es das erfindungsgemäße mikroskopische System zur Prüfung von Strukturen und Defekten auf EUV-Photomasken als Objekt 6 darstellt.

Als plasmabasierte EUV-Quellen kommen nur LPP- oder DPP- Laserquellen (DPP - Discharge Produced Plasma) für eigenständige EUV-Mikroskope in Frage und sind durch ihre Kompaktheit das Mittel der Wahl für eigenständige "labortaugliche" EUV-Technologieinstallationen.

Laser- und entladungserzeugte Quellen (LPP- und DPP-Quellen), die Zinn oder Xenon als Emitterelemente für das EUV verwenden und ca. seit dem Jahr 2000 im EUV-Lithographie-Prozess und auch für die "aktinische" Qualifizierungsmetrologie im Einsatz sind, werden mit der Erfindung auf Emitterelemente kleiner Ordnungszahlen Z < 20 (bevor-zugt $Z \leq 10$ und insbesondere $2 \leq Z \leq 8$) umgestellt, die die charakteristische Eigenschaft von dominanten freistehenden Emissionslinien aufweisen und dadurch die spektrale Filterung vereinfachen und die optische hochauflösende Bildaufnahme mittels Fresnel-Zonenplattenobjektiv 7 im EUV-Bereich entsprechend der Arbeitswellenlänge der EUV-Lithographiescanner ermöglichen. Unter Berücksichtigung der Grundlagen der Zonenplattenabbildung ist eine spektrale Filterung der Emission unabdingbar. Obwohl Emitterelemente, die bevorzugt schmalbandige Linienstrahlung erzeugen, den Aufwand für die spektrale Filterung deutlich verringern, ist immer noch die Unterdrückung von Nicht-EUV-Emissionen vom Vakuum-Ultraviolett-, Ultraviolett-, sichtbaren bis zum Infrarot-Spektralbereich zusätzlich - für die gewünschte hohe Auflösung -auf eine schmale EUV-Bandbreite erforderlich. Als Mittel zur Unterdrückung von Nicht-EUV-Emissionen werden dünne metallische Transmissions-Filterfolien verwendet. Bevorzugt sind das Metallfolien oder mit Metallen beschichtete Folien, die UV-, VIS- und IR-Strahlung reflektieren und VUV-Strahlung absorbieren. Für eine annehmbare EUV-Transmission von mindestens einigen Prozent muss die Dicke solcher Folien jedoch unterhalb von 1 $\mu$m sein. Typischerweise werden z.B. 200 nm Zirkonium- oder Niobfilme verwendet. Es wäre aber auch die Beugung an einem Gitter mit Auswahl der gewünschten Wellenlänge möglich.

Zur Breitbandfilterung kann die Reflexion von EUV an einem mit Vielschichtfilter beschichteten Spiegel, wie er auch in den lithografischen und AIMS-Spiegelsystemen verwendet wird, eingesetzt werden, wenn sie effizient gewählt eine Bandbreite von $\lambda/\Delta\lambda$ = N aufweisen, wobei hier N die Anzahl der Schichtpaare bedeutet.

Da zum Fokussieren des EUV-Strahls auf das Objekt 6 ohnehin mehrschichtige Spiegel 3a, 3b verwendet werden, können diese "lenkenden oder kondensierenden optischen Elemente" so konstruiert werden, dass sie sowohl eine "Fokussierung" als auch eine spektrale Filterung bewirken. Solche "Vielschichtfilter" (Wechselschichtsysteme) können auch als reflektierende Schichten auf dünnen Transmissionsfenstern ausgebildet sein, beispielsweise von dem Typ, der zur Unterdrückung der oben beschriebenen Nicht-EUV-Emission verwendet wird.

Außerdem könnten auch prinzipiell Monochromatoren - wie aus dem sichtbaren- und Röntgenbereich bekannt - optimiert für EUV-Strahlung, eingesetzt werden.

Kerngedanke des erfindungsgemäßen mikroskopischen Systems ist die Auswahl des Emittermaterials für die Erzeugung des EUV-emittierenden Plasmas. Indem "Niedrig-Z"-Emitterelemente mit schmalbandigen, freistehenden Emissionslinien aus dem Periodensystem der Elemente ausgewählt werden, sodass sie die Zentralwellenlänge der gewünschten schmalbandigen EUV-Strahls so gut wie möglich "treffen". Dieser Kern dieser Erfindung basiert auf eigenen experimentellen Erfahrungen, dass eine EUV-Strahlungsquelle 1 so ausgelegt und optimiert werden kann, dass sie nur einige freistehende bzw. isolierte intensive Emissionslinien im EUV-Spektralbereich emittiert. Wie aus eigenen Experimenten ermittelt, haben solche Emissionslinien eine Bandbreite von $\lambda/\Delta\lambda$ > 1500. Die Eigenschaft einer freistehenden Emissionslinie, d.h. einer dominanten, intensiven und gut separierten Emissionslinie, ist aber nur bei Elementen des Periodensystems mit niedrigen Ordnungszahlen Z (kurz: "Niedrig-Z"-Elemente) ab Lithium (Z = 3) über Kohlenstoff (Z = 6), Stickstoff (Z = 7), Sauerstoff (Z = 8), Fluor (Z = 9) bis Neon (Z = 10) verfügbar.

Bei Betrachtung der interessierenden schmalen Spektralbandbreite liefern solche Elemente "Plasmaresonanzlinien" mit einem viel höheren Photonenfluss und einer viel höheren spektralen Helligkeit (Brillanz), wenn man sie mit der Anregung von Breitbandemittern bei gleicher Menge an Eingangsenergie vergleicht.

Durch die Optimierung der Anregungsparameter (bei DPP: Entladungsspannung und Impulsenergie; bei LPP: Impulsdauer, Intensität, Punktgröße) auf das jeweilige "Niedrig-Z"-Emitterelement sind die erzeugten Emissionslinien durch $\Delta\lambda$ > $\lambda/50$ = 0,27 nm getrennt und werden als isoliert bzw. freistehend betrachtet. Mit einer solchen "isolierten Linienemitterquelle" kann eine Breitbandfilterung leicht durch Vielschichtreflexionen mit einer viel höheren Effizienz als bei jeder Monochromatorlösung erreicht werden.

Für das Mikroskop gibt es einen speziellen Weg, um eine Strahlung von $\lambda/\Delta\lambda$ > 1000 zu erhalten, bei dem ein Element verwendet wird, das eine schmalbandige isolierte Linienstrahlung nahe der angestrebten Arbeitswellenlänge von 13,5 nm emittiert. Eine andere Breitbandemission jenseits dieser einen Emissionslinie kann einfach gefiltert werden, indem einige vielschichtige Wechselschichtspiegel im Strahlengang vorhanden sind, die das Licht mit jeweils etwa 60% Reflexionsvermögen auf etwa $\lambda/\Delta\lambda$ < 50 grob filtern. Außerhalb der IR-Banden werden VIS und UV nur durch ein spektrales Dünnfilm-Filterfenster blockiert. Grundsätzlich haben alle Elemente von Helium bis Neon einige dieser freistehenden schmalbandigen Linien - jedoch nur wenige im für die EUV-Technologie interessanten Spektralbereich von 12-16 nm. Die anderen Elemente können es jedoch ermöglichen, diese Technik auf andere interessierende Anwendungswellenlängen im XUV- und VUV-Spektralbereich zu übertragen.

Lithium als bevorzugtes Emitterelement

Lithium als Emitterelement zeichnet sich dadurch aus, dass es seine stärkste Emissionslinie bei genau 13,5 nm abstrahlt, wodurch Lithium für Anwendungen im

Umfeld der EUVL besonders interessant ist. Wie oben beschrieben, wird Lithium selten als EUV-Emitterelement verwendet, da es eine Umwandlungseffizienz in die für die EUVL nutzbare Bandbreite von 2% von etwa 1% im Vergleich zu Werten mit Xenon (3%) oder Zinn (bis zu 6%) aufweist.

Eine Filterung auf $\lambda/\Delta\lambda$ = 1500 durch Vielschichtreflexionen an einem Interferenzfiltersystem mit einer ungünstigstenfalls 30%igen Effizienz insgesamt (jedenfalls für jede Lösung anzusetzen) hätte jedoch keinen spektralen Verlust, da die Emissionslinie diese enge Bandbreite von Natur aus aufweist.

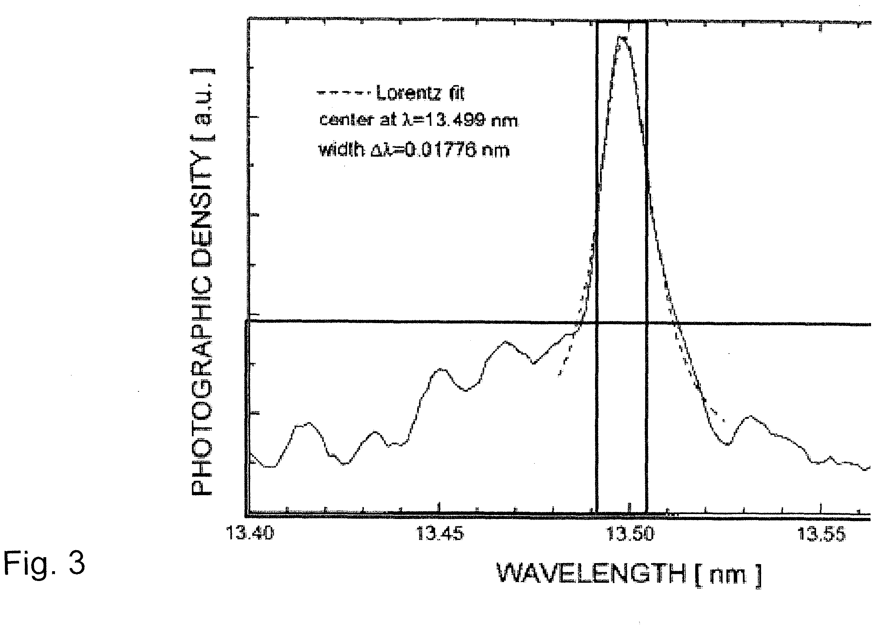

Fig. 3 zeigt die Lyman-alpha (Ly$_\alpha$)-Emissionslinie bei 13,5 nm, aufgelöst mit einem Spektrographen von $\lambda/\Delta\lambda <$ 700 in zweiter Ordnung. Das Diagramm zeigt eine Bandbreite dieser Emissionslinie von $\lambda/\Delta\lambda > 1400$, die bereits nahezu perfekt für hochauflösende Bildgebung ist, während die gemessene Bandbreite durch die Auflösung des Spektrographen immer noch als begrenzt angesehen wird.

Zusammenfassend lässt sich sagen, dass eine Lithiumquelle bei einer Zielbandbreite von $\lambda/\Delta\lambda = 1500$ eine Gesamteffizienz von 0,3% erreichen würde, während die Effizienz infolge der Filterung bei Xenon auf 0,02% und bei Zinn auf 0,03% abfallen würde. Daher ist eine Lithiumquelle bei gleicher Eingangsleistung bezüglich des Durchsatzes (Throughput) mindestens 10-mal schneller als eine Zinnquelle und mehr als 20-mal schneller als eine Xenonquelle.

Beispiel einer bevorzugten Ausführungsform

Verschiedene Aspekte der vorliegenden Erfindung ergeben sich aus der folgenden detaillierten Beschreibung der bevorzugten Ausführungsformen der Erfindung unter Bezugnahme auf die oben angegebenen Zeichnungen.

Bevorzugte Ausführungsformen der vorliegenden Erfindung sind in den Zeichnungen von Fig. 1, Fig. 4 und Fig. 5 gezeigt.

Eine kompakte plasmabasierte EUV-Strahlungsquelle 1, die - unter anderen Wellenlängen (IR, VIS, UV) - vor allem EUV-Strahlung im Spektralbereich von 12-20 nm mit großer Helligkeit emittiert. Die Plasmaemission (DPP oder LPP) ist thermisch (d.h. Isotrope und nicht kohärente elektromagnetische Strahlungsimpulse). Solche Strahlungsquellen sind im Allgemeinen verfügbar.

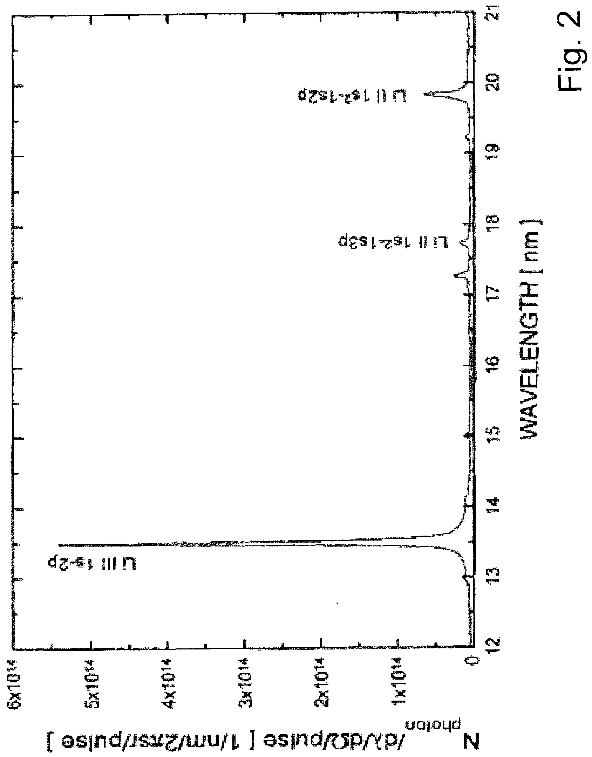

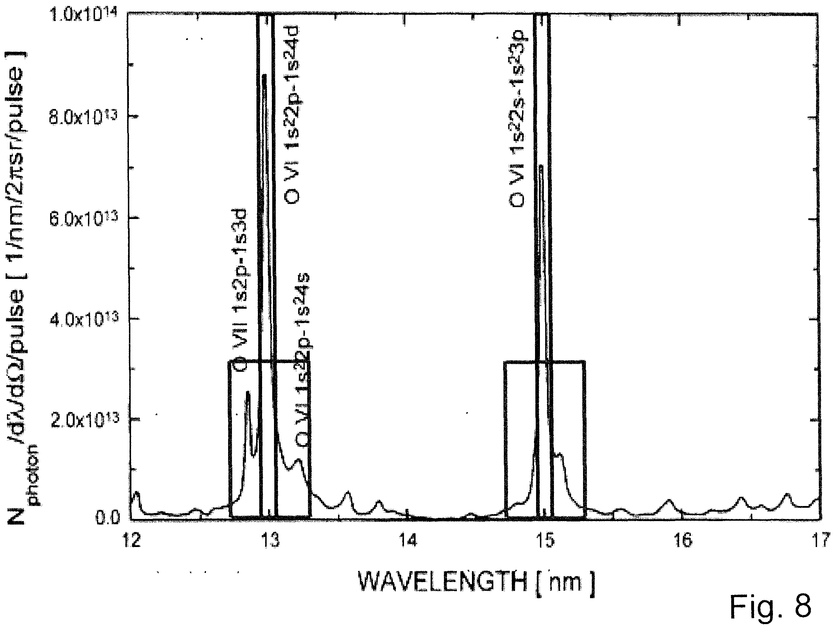

Die spektrale Emission 2 der hier verwendeten EUV-Strahlungsquelle 1 ist hauptsächlich auf eine intensive freistehende Emissionslinie (siehe Fig. 2 und 3) nahe der EUVL-Wellenlänge von 13,5 nm eingestellt, indem ein Element mit niedrigem Z-Wert (Ordnungszahl im Periodensystem der Elemente) als Emittermaterial gewählt wird, das schmalbandige freistehende Emissionslinien im Spektralbereich zwischen 13-15 nm (siehe z. B. das Emissionsspektrum von Sauerstoff in Fig. 8) emittiert.

Ein ideales Emitterelement mit solchen Eigenschaften ist für die derzeitige EUV-Arbeitswellenlänge Lithium mit einer starken, schmalbandigen und freistehenden Linie bei 13,5 nm, das hier ohne Beschränkung der Allgemeinheit als Emitter angenommen wird. Das emittierende Plasma als Quellvolumen und ein Volumen, in dem Objekte 6 (EUV-Photomasken) untersucht werden, sind durch mindestens ein Dünnschicht-Filterfenster 4 (typischerweise 50-500 nm dick) getrennt, das vorzugsweise metallisch oder mit einem Metall (z. B. mit Zirkonium oder Nickel) beschichtet ist, um langwellige Strahlung (IR-VIS-UV) zu reflektieren bzw. zu blockieren und VUV-Strahlung zu absorbieren. Dieses Filterfenster 4 kann sich auf dem Weg zum Objekt 6 (Photomaske) an einer beliebigen Stelle im Strahlengang befinden

Die Emission 2 der Strahlungsquelle 1 wird über mindestens ein mehrschichtig beschichtetes optisches Element 3a und 3b entweder direkt zum Objekt 6 oder zu einem Kondensor 5 geführt, der - wiederum als vielschichtig beschichtetes optisches Element - ein Strahlenbündel zum Objekt 6 führt. Beleuchtungs- und Abbildungseigenschaften können durch zusätzliche optische Elemente im Strahlengang unterstützt werden. Beispiele sind Reflexionsspiegel mit streifendem Strahleinfall oder ein Kondensorspiegel.

Die Kombination von schmalbandiger Lithiumemission, breitbandiger EUV-Filterung durch die Vielschichtreflexionen und metallischem Filterfenster 4 stellt sicher, dass nur Strahlung mit der gewünschten zentralen Wellenlänge $\lambda$ und Bandbreite ($\lambda/\Delta\lambda$) auf das Objekt 6 trifft.

Diese Strahlung wird dann von der Oberfläche des Objekts 6 reflektiert und kann mit einer Zonenplatte 7 von > 1 $\mu$m Durchmesser - da sie im Wesentlichen nur noch schmalbandiges EUV nahe 13,5 nm enthält - mit hoher Auflösung und Effizienz abgebildet werden. Die Abstände der Zonenplatte 7 zum Objekt 6 sind so bemessen, dass ein vergrößertes Bild des Objekts 6 auf die Oberfläche Detektors 8 abgebildet wird.

Dies ermöglicht die Vergrößerung der räumlichen Reflexionsschwankungen vom Objekt 6 durch Verwendung eines Fresnel-Zonenplattenobjektivs auf das 1000-fache, sodass das vergrößerte Bild mit einer Auflösung von bis zu 20 nm mit einem EUVempfindlichen Detektor-Array (z.B. rückseitenbeleuchtetes CCD, CMOS-Kamera usw.), obwohl solche Kameras Pixel von typischerweise 13,5 $\mu$m im Quadrat haben. Das im Detektor 8 erzeugte Signal wird elektronisch zur Auswertung der aufgenommenen Strukturen an einen Computer 9 übertragen, der die Anzeige und weitere Bildverarbeitung ermöglicht.

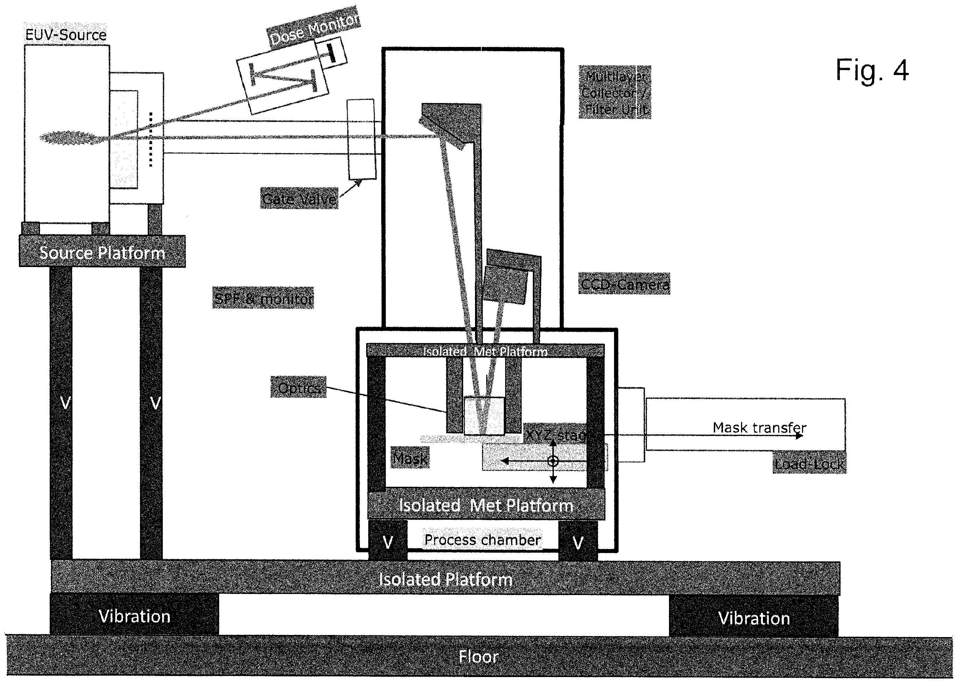

Angelehnt an das Grundschema von Fig. 1 zeigt Fig. 4 ein vorteilhaft ausgeführtes Schema eines kompletten EUV-Reflexionsmikroskops unter Verwendung der vorgeschlagenen Erfindung, wobei, da die EUV-Quelle 1 eine passende intensive, freistehende Emissionslinie aufweist, lediglich die Reflexion an zwei mit Vielschichtspiegeln beschichteten Oberflächen 3a, 3b und ein Metallfolienfilter als Spektralfilteranordnung ausreichen. Als Filter fügt das Objekt 6 üblicherweise eine weitere spektral filternde Reflexion hinzu, die die Funktion der hochauflösenden Abbildung der Fresnel-Zonenplatte 7 weiter verbessert. Dadurch kann als Mikroskopobjektiv eine Fresnel-Zonenplatte 7 eingesetzt werden, die - wie in Fig. 6 gezeigt - eine hervorragende Abbildung der Oberflächenstrukturen des Objekts 6 auf dem EUV-Detektorarray 8 erzeugt.

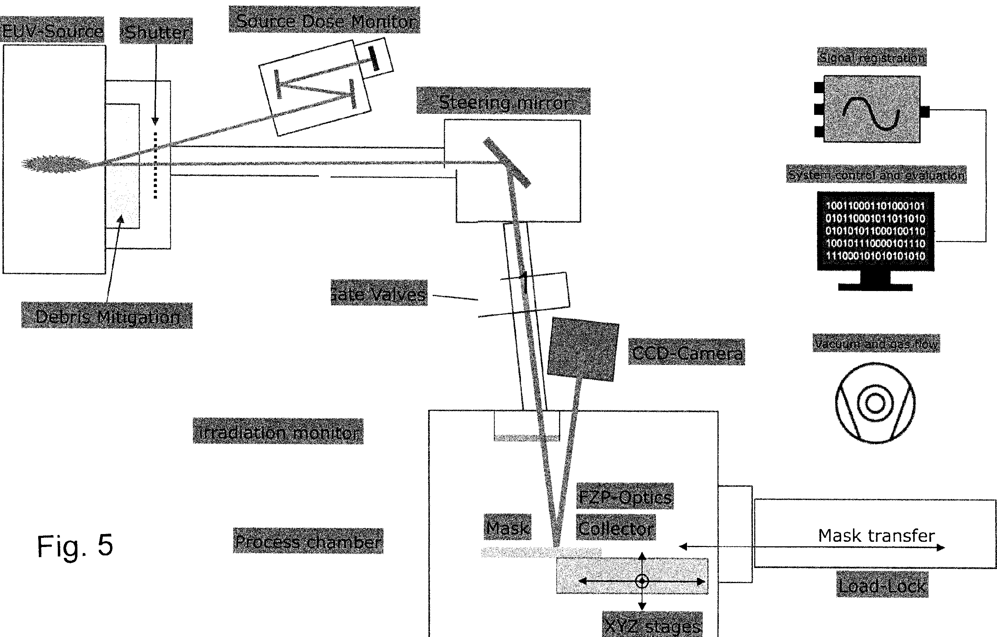

In Fig. 5 ist ein weiteres Prinzipschema eines EUV-Reflexionsmikroskops unter Einsatz der kompakten erfindungsgemäßen EUV-Strahlungsquelle 1 mit einer Plasmaquelle, dessen Emitterelement eine dominante freistehende Emissionslinie aufweist und deshalb mit einfachen Filtermitteln aus Vielschichtfilterspiegeln und einem Bandpass (SPF) den Einsatz eines Fresnel-Zonenplattenobjektivs im EUV-Mikroskop gestattet.

**Patentansprüche**

1. Mikroskopisches System zur Überprüfung von Strukturen und Defekten auf EUV-Lithographie-Photomasken, umfassend:

    - eine eigenständige plasmabasierte EUV-Strahlungsquelle (1) mit einem Emissionsspektrum (2), das wenigstens eine dominierende freistehende schmalbandige Emissionslinie im Spektralbereich von 12,5 bis 14,5 nm enthält, wobei die schmalbandige Emissionslinie eine relative Bandbreite von $\lambda/\Delta\lambda > 1000$ aufweist,
    - Mittel zum Beleuchten eines strukturierten Objekts (6) mit der schmalbandigen Emissionslinie der EUV-Strahlungsquelle (1), wobei das Objekt (6) die schmalbandige Linienstrahlung reflektiert, umfassend
    - Mittel (3a, 3b) zum Unterdrücken von Strahlung mit Wellenlängen, die außerhalb des EUV-Spektralbereichs liegen und mindestens länger als 20 nm sind,
    - Mittel (4) zur Breitband-Spektralfilterung $\lambda/\Delta\lambda < 50$ zum Auswählen der dominierenden freistehenden Emissionslinie aus dem Emissionsspektrum (2) der EUV-Strahlungsquelle (1), wobei die Mittel (4) zur Breitband-Spektralfilterung an beliebiger Stelle im Strahlengang bis zum Objekt (6) angeordnet sind,
    - ein Objektiv mit einer Fresnel-Zonenplatte zur vergrößerten Abbildung des Objekts (6) mit einer Auflösung von kleiner als 100 nm und einer numerischen Apertur, die bei vorgegebener Wellenlänge $\lambda$ der schmalbandigen Emissionslinie direkt von der Breite der äußersten Zone der Zonenplatte (7) abhängig ist, und
    - ein EUV-empfindliches zweidimensionales Detektorarray (8) zur Aufnahme der vergrößerten Abbildung des strukturierten Objekts (6).

2. System nach Anspruch 1, bei dem die EUV-Strahlungsquelle (1) eine plasmabasierte Quelle ist, die durch einen auf ein Target fokussierten Laserstrahl erzeugt ist.

3. System nach Anspruch 1, bei dem die EUV-Strahlungsquelle (1) eine plasmabasierte Quelle ist, die durch eine elektrische Gasentladung erzeugt ist.

4. System nach einem der Ansprüche 1 bis 3, bei dem die EUV-Strahlungsquelle (1) eine Resonanzlinienemission eines Emitterelements mit niedriger Ordnungszahl $Z < 20$ aufweist.

5. System nach einem der Ansprüche 1 bis 4, bei dem die EUV-Strahlungsquelle (1) eine isolierte schmalbandige Resonanzlinienemission unter Verwendung wenigstens eines der Emitterelemente von Lithium, Kohlenstoff, Stickstoff, Sauerstoff, Fluor, Neon und Argon aufweist.

6. System nach einem der Ansprüche 1 bis 5, bei dem die Emissionslinie der EUV-Strahlungsquelle (1) durch eine Lyman-alpha ($\text{Ly}_\alpha$)-Emissionslinie von Lithium bei 13,5 nm erzeugt ist.

7. System nach einem der Ansprüche 1 bis 6, bei dem ein optisches Element (3a, 3b) zur Breitband-Spektralfilterung vorhanden ist, das eine Spektralfilterung von besser 0,6 nm bei einer Arbeitswellenlänge von 13,5 nm erreicht.

8. System nach einem der Ansprüche 1 bis 6, bei dem die Breitband-Spektralfilterung realisiert ist durch Kombination eines Nicht-EUV-SPF-Filters (4) mit Einzel- oder Mehrfachreflexionen von Spiegeln (3a, 3b), die mit Vielschichtinterferenzfiltern beschichtet und so eingestellt sind, dass sie eine gewählte Arbeitswellenlänge reflektieren, wobei die Kombination in beliebiger Reihenfolge angeordnet sein kann.

9. System nach Anspruch 8, bei dem die Spiegel (3a, 3b) für die Einzel- oder Mehrfachreflexionen mit Vielschichtinterferenzfiltern mit Schichtpaaren aus Silizium und Molybdän beschichtet sind.

10. System nach einem der Ansprüche 1 bis 6, bei dem zur Breitband-Spektralfilterung ein eher breitbandiges EUV-Filter wie bei Vielschichtreflexion vorhanden ist, sodass aufgrund der isolierten Emissionslinie eine effektive Bandbreite von $\lambda/\Delta\lambda > 500$, insbesondere $> 1000$, eingestellt ist.

**Claims**

1.  A microscopic system for testing structures and defects on EUV lithography photomasks, comprising:

    - a stand-alone plasma-based EUV radiation source (1) with an emission spectrum (2) containing at least one dominant free-standing narrowband emission line in the spectral range from 12.5 to 14.5 nm, wherein the narrowband emission line has a relative bandwidth of $\lambda/\Delta\lambda > 1{,}000$,
    - means for illuminating a structured object (6) with the narrowband emission line of the EUV radiation source (1), the object (6) reflecting the narrowband line radiation, comprising
    - means (3a, 3b) for suppressing radiation with wavelengths which are outside of the EUV spectral range and are at least longer than 20 nm,
    - means (4) for broadband spectral filtering $\lambda/\Delta\lambda < 50$ for selecting the dominant free-standing emission line from the emission spectrum (2) of the EUV radiation source (1), wherein the means (4) for broadband spectral filtering are arranged at any position in the beam path up to the object (6),
    - an objective with a Fresnel zone plate for magnified imaging of the object (6) with a resolution of less than 100 nm and a numerical aperture which is directly dependent on the width of the outermost zone of the zone plate (7) for a given wavelength $\lambda$ of the narrowband emission line, and
    - an EUV-sensitive two-dimensional detector array (8) for capturing the magnified image of the structured object (6).

2.  The system according to claim 1, wherein the EUV radiation source (1) is a plasma-based source which is generated by a laser beam focused on a target.

3.  The system according to claim 1, wherein the EUV radiation source (1) is a plasma-based source which is generated by an electric gas discharge.

4.  The system according to any one of claims 1 to 3, wherein the EUV radiation source (1) comprises a resonant line emission of an emitter element with a low atomic number $Z < 20$.

5.  The system according to any one of claims 1 to 4, wherein the EUV radiation source (1) comprises an isolated narrowband resonant line emission using at least one of the emitter elements of lithium, carbon, nitrogen, oxygen, fluorine, neon and argon.

6.  The system according to any one of claims 1 to 5, wherein the emission line of the EUV radiation source (1) is generated by a Lyman-alpha (Ly$\alpha$) emission line of lithium at 13.5 nm.

7.  The system according to any one of claims 1 to 6, wherein an optical elements (3a, 3b) is provided for broadband spectral filtering, which achieves a spectral filtering of better than 0.6 nm at a working wavelength of 13.5 nm.

8.  The system according to any one of claims 1 to 6, wherein the broadband spectral filtering is realized through a combination of a non-EUV SPF filter (4) with individual reflections or multiple reflections of mirrors (3a, 3b) which are coated with multilayer interference filters and are adjusted such that they reflect a selected working wavelength, wherein the combination can be arranged in any order.

9.  The system according to claim 8, wherein the mirrors (3a, 3b) for the individual reflections or multiple reflections are coated with multilayer interference filters with layer pairs of silicon and molybdenum.

10. The system according to any one of claims 1 to 6, wherein a rather broadband EUV filter is present for broadband spectral filtering as in multilayer reflection, so that an effective bandwidth of $\lambda/\Delta\lambda > 500$, in particular $> 1000$, is set due to the isolated emission line.

**Revendications**

1.  Système microscopique pour tester des structures et de défauts sur des photomasques de lithographie EUV, comprenant :

    - une source de rayonnement EUV autonome à base de plasma (1) ayant un spectre d'émission (2) comprenant au moins une raie d'émission à bande étroite autonome dominante dans la plage spectrale de 12,5 à 14,5 nm, ladite raie d'émission à bande étroite ayant une largeur de bande relative de $\lambda/\Delta\lambda > 1000$,

- des moyens pour éclairer un objet structuré (6) avec la raie d'émission à bande étroite de la source de rayonnement EUV (1), l'objet (6) réfléchissant le rayonnement de la raie à bande étroite, comprenant
- des moyens (3a, 3b) pour supprimer le rayonnement dont les longueurs d'onde se situent en dehors de la gamme spectrale EUV et sont au moins supérieures à 20 nm,
- des moyens (4) de filtrage spectral à large bande $\lambda/\Delta\lambda < 50$ pour sélectionner la raie d'émission autonome dominante dans le spectre d'émission (2) de la source de rayonnement EUV (1), les moyens (4) de filtrage spectral à large bande étant disposés en un point quelconque du trajet de faisceau jusqu'à l'objet (6),
- un objectif avec une plaque zonée de Fresnel pour la reproduction agrandie de l'objet (6) avec une résolution inférieure à 100 nm et une ouverture numérique qui, pour une longueur d'onde $\lambda$ donnée de la raie d'émission à bande étroite, dépend directement de la largeur de la zone la plus extérieure de la plaque zonée (7), et
- un réseau de détecteurs bidimensionnels (8) sensibles aux EUV pour enregistrer l'image agrandie de l'objet structuré (6).

2. Système selon la revendication 1, dans lequel la source de rayonnement EUV (1) est une source à base de plasma générée par un faisceau laser focalisé sur une cible.

3. Système selon la revendication 1, dans lequel la source de rayonnement EUV (1) est une source à base de plasma générée par une décharge électrique dans un gaz.

4. Système selon l'une quelconque des revendications 1 à 3, dans lequel la source de rayonnement EUV (1) comprend une émission de raie de résonance d'un élément émetteur de numéro atomique faible Z < 20.

5. Système selon l'une quelconque des revendications 1 à 4, dans lequel la source de rayonnement EUV (1) comprend une émission isolée de raies de résonance à bande étroite utilisant au moins l'un des éléments émetteurs de lithium, carbone, azote, oxygène, fluor, néon et argon.

6. Système selon l'une quelconque des revendications 1 à 5, dans lequel la raie d'émission de la source de rayonnement EUV (1) est générée par une raie d'émission Lyman-alpha (Ly$\alpha$) du lithium à 13,5 nm.

7. Système selon l'une quelconque des revendications 1 à 6, dans lequel il est prévu un élément optique (3a, 3b) de filtrage spectral à large bande qui permet d'obtenir un filtrage spectral meilleur que 0,6 nm à une longueur d'onde de travail de 13,5 nm.

8. Système selon l'une quelconque des revendications 1 à 6, dans lequel le filtrage spectral à large bande est réalisé en combinant un filtre SPF non-EUV (4) avec des réflexions simples ou multiples de miroirs (3a, 3b) revêtus de filtres interférentiels multicouches et réglés pour réfléchir une longueur d'onde de travail choisie, la combinaison pouvant être disposée dans n'importe quel ordre.

9. Système selon la revendication 8, dans lequel les miroirs (3a, 3b) pour les réflexions simples ou multiples sont revêtus de filtres interférentiels multicouches avec des paires de couches de silicium et de molybdène.

10. Système selon l'une quelconque des revendications 1 à 6, dans lequel, pour le filtrage spectral à large bande, il est prévu un filtre EUV plutôt à large bande comme pour la réflexion multicouche, de sorte qu'en raison de la ligne d'émission isolée, une largeur de bande effective de $\lambda/\Delta\lambda > 500$, notamment > 1000, est réglée.

Fig. 1

EP 4 032 106 B1

Fig. 2

Fig. 3

Fig. 4

Fig. 5

Fig. 6

10 nm

12 nm

15 nm

20 nm

>= 20 nm "resolution" zone plates are available

Fig. 7

$$R_n = \sqrt{n\lambda f + \frac{1}{4}n^2\lambda^2}$$

$2\,R_N$

$\Delta x_{min} \approx 1.22 * \Delta R_N$

$$\Delta R_N = \frac{\lambda}{2\,NA}$$

$f$

$$f = \frac{2R_N\,\Delta R_N}{\lambda}$$

EP 4 032 106 B1

Fig. 8

**IN DER BESCHREIBUNG AUFGEFÜHRTE DOKUMENTE**

**In der Beschreibung aufgeführte Patentdokumente**

- US 6738135 B
- US 6894837 B2
- DE 10319269 A1
- US 5222113 A
- US 5311565 A
- US 5177774 A
- EP 459833 A
- US 6469827 B
- US 5022064 A
- DE 10130212 A
- US 6738135 B1
- US 6894837 B
- DE 102007041939 A1